# EUROPÄISCHE PATENTSCHRIFT

(11) **EP 2 935 499 B1**
(45) Veröffentlichungstag und Bekanntmachung des Hinweises auf die Patenterteilung: **16.06.2021**
(21) Anmeldenummer: 13799576.7
(22) Anmeldetag: 05.12.2013
(51) Int. Cl.: C09J 7/22, C09J 7/29, C08K 3/22, C08K 3/34, H01L 51/52

(54) **VERFAHREN ZUM ENTFERNEN VON PERMEATEN AUS FLÄCHENGEBILDEN**
METHOD FOR REMOVING PERMEATES FROM FLAT STRUCTURES
PROCÉDÉ POUR ÉLIMINER DES PERMÉATS CONTENUS DANS DES STRUCTURES PLANES

(30) Priorität: 21.12.2012 DE 102012224319; 15.02.2013 DE 102013202473
(43) Veröffentlichungstag der Anmeldung: 28.10.2015
(73) Patentinhaber: tesa SE, 22848 Norderstedt (DE)
(72) Erfinder: KEITE-TELGENBÜSCHER, Klaus, 22529 Hamburg (DE); SCHUH, Christian, 22767 Hamburg (DE); SCHABERNACK, Thomas, 65510 Idstein (DE)
(74) Vertreter: tesa SE
(86) Internationale Anmeldenummer: PCT/EP2013/075631
(87) Internationale Veröffentlichungsnummer: WO 2014/095385

(56) Entgegenhaltungen:
- EP-A2- 1 383 182
- EP-A2- 2 200 105
- WO-A1-2014/001005
- Anonymous: "Lithiumaluminiumhydrid", , 1 December 2007 (2007-12-01), pages 1-3, XP055664368, Retrieved from the Internet: URL:https://roempp.thieme.de/lexicon/RD-12 -01348#/ [retrieved on 2020-02-03]

## Beschreibung

Die Erfindung betrifft das technische Gebiet der funktionalisierten Klebebänder. Es werden ein Verfahren zum Entfernen von Permeaten aus einem Flächengebilde vorgeschlagen. Optoelektronische Anordnungen werden immer häufiger in kommerziellen Produkten verwendet oder stehen kurz vor der Markteinführung. Derartige Anordnungen umfassen anorganische oder organische elektronische Strukturen, beispielsweise organische, metallorganische oder polymere Halbleiter oder auch Kombinationen davon. Die entsprechenden Produkte sind je nach gewünschter Anwendung starr oder flexibel ausgebildet, wobei eine zunehmende Nachfrage nach flexiblen Anordnungen besteht. Die Herstellung derartiger Anordnungen erfolgt häufig durch Druckverfahren wie Hochdruck, Tiefdruck, Siebdruck, Flachdruck oder auch so genanntes "non impact printing" wie etwa Thermotransferdruck, Tintenstrahldruck oder Digitaldruck. Vielfach werden aber auch Vakuumverfahren wie beispielsweise Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung verwendet. Die Strukturierung erfolgt in der Regel durch Masken.

Als Beispiele für bereits kommerziell erhältliche oder in ihrem Marktpotential interessante optoelektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, ferner Elektrolumineszenzlampen, Licht emittierende elektrochemische Zellen (LEECs), organische Solarzellen wie Farbstoff- oder Polymersolarzellen, anorganische Solarzellen, insbesondere Dünnschichtsolarzellen, zum Beispiel auf der Basis von Silizium, Germanium, Kupfer, Indium und Selen, organische Feldeffekt-Transistoren, organische Schaltelemente, organische optische Verstärker, organische Laserdioden, organische oder anorganische Sensoren oder auch organisch- oder anorganisch basierte RFID-Transponder angeführt.

Als technische Herausforderung für die Realisierung einer ausreichenden Lebensdauer und Funktion von optoelektronischen Anordnungen auf dem Gebiet der anorganischen und organischen Optoelektronik, ganz besonders der organischen Optoelektronik, ist ein Schutz der darin enthaltenen Komponenten vor Permeaten zu sehen. Als Permeate werden dabei in der Regel gasförmige oder flüssige Stoffe angesehen, die in einen Festkörper eindringen und diesen gegebenenfalls durchdringen beziehungsweise durchwandern. Dementsprechend können viele niedermolekulare organische oder anorganische Verbindungen Permeate sein, wobei im vorliegend beschriebenen Zusammenhang Wasserdampf und Sauerstoff von besonderer Bedeutung sind.

Eine Vielzahl von optoelektronischen Anordnungen - besonders bei Verwendung von organischen Materialien - ist sowohl gegen Wasserdampf als auch gegen Sauerstoff empfindlich. Während der Lebensdauer der elektronischen Anordnungen ist deshalb ein Schutz durch eine Verkapselung erforderlich, da andernfalls die Leistung über den Anwendungszeitraum nachlässt. Bei mangelhaftem Schutz können sich beispielsweise durch Oxidations- oder Hydrolyseprozesse bei Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kurzer Zeit drastisch verringern.

Neben dem Schutz vor eindringenden Permeaten ist aber auch die Entfernung schädlicher Permeate aus vielen im Aufbau der elektronischen Anordnung selbst verwendeten Materialien unbedingt notwendig. Insbesondere die bei flexiblen Aufbauten häufig verwendeten polymeren Substrat-, Abdeck- oder Verklebungsfolien enthalten selbst oft schädliches Permeat, insbesondere Wasser, so dass diese Materialien aufwändig getrocknet werden müssen.

Weiterhin werden insbesondere bei der kontinuierlichen Herstellung von flächigen elektronischen Anordnungen Materialien eingesetzt, die nur als Hilfsmaterialien fungieren, wie z.B. temporäre Trägermaterialien, auf denen z.B. diskrete Einheiten platziert und durch aufeinander folgende Prozessierungsstufen transportiert werden.

Auch Hilfsmaterialien, von denen nur Teile im Elektronischen Aufbau verbleiben, werden verwendet und sind dementsprechend permeatfrei zur Verfügung zu stellen.

Insbesondere permeatfrei zur Verfügung zu stellen ist beispielsweise eine Trägerfolie, wie sie beim "Laser Induced Thermal Imaging" (LITI) zur Bereitstellung und zum Transfer der organischen lichtemittierenden Schicht verwendet wird, da diese in direktem Kontakt zu den empfindlichen Materialien steht.

Weiterhin werden Zwischenstufen in der Herstellung flächiger elektronischer Aufbauten mitunter mit Materialien beschichtet oder bedruckt, die in wässriger Dispersion vorliegen. So werden z.B. Elektronen- oder Lochtransportschichten aus intrinsisch leitfähigen Polymeren wie Clevios (PEDOT:PSS; Heraeus Precious Metals) hergestellt. Solche Schichten müssen aufwändig zu einem hohen Grad vom Wasser befreit werden, da sie in direktem Kontakt zu den empfindlichen Materialien stehen.

Verfahren zur Trocknung oder zum Trockenhalten von Flächengebilden finden aber auch Verwendung in anderen Anwendungsfeldern, z.B. in der Pharmazie bei der Herstellung und Lagerung von wirkstoffhaltigen Pflastern oder medizinischen Diagnosestreifen; in der chemischen Analytik bei der Extraktion zu analysierender Substanzen oder ganz allgemein zur Abdeckung von Sensoren.

Wirkstoffhaltige Pflaster bzw. Transdermale Therapeutische Systeme (TTS, TDS) wurden 1979 in den Markt eingeführt und werden heute mit einer Reihe von Wirkstoffen in großem Umfang eingesetzt. Mit diesen Systemen, die rein optisch herkömmlichen Pflastern vergleichbar sind, werden Wirkstoffe (z. B. Hormone, Nikotin u. a.) durch die Haut transdermal verabreicht. Der Vorteil dieser Darreichungsform besteht im Übergang des Wirkstoffes in die Blutgefäße unter Umgehung des gastrointestinalen Trakts. Damit wird das Magen-Darm-System geschont und die Verstoffwechselung des Wirkstoffes durch das hepatische System vor Erreichen des Wirkortes reduziert. Weiterhin wird die Patientenakzeptanz (Compliance) verbessert, weil die Applikation der Systeme nicht täglich, sondern nur noch in größeren Zeitabständen erfolgt. Ähnlich verhält es sich mit oral applizierten löslichen Filmen (Oral Dissolvable Films, ODF).

Die Vorteile von TTS und ODF könnten noch deutlicher zum Tragen kommen, wenn die Wirkstoffabgabe aus solchen Systemen interaktiv und kontrolliert erfolgte. Dazu gehört z.B. die Freisetzung oder Mobilisierung von Wirkstoffen durch Permeate, wie z.B. Wasserdampf oder Sauerstoff, die erst nach der Applikation in das System eindringen dürfen. Demzufolge besteht ein Bedarf, solche Wirkstoffpflaster nach der Herstellung von Permeat zu befreien und permeatfrei zu halten sowie am Patienten zur Verfügung zu stellen.

Verfahren zur Aufnahme von Permeaten aus bestimmten Materialien mittels Klebstoffen sind im Stand der Technik grundsätzlich bekannt.

US 6,103,141 beschreibt beispielsweise eine trockenmittelgefüllte Heißschmelzklebemasse, welche in Form eines Klebebands zur Verfügung gestellt wird. Dieses Tape wird auf die Innenseite eines Behälters geklebt, um den Behälterraum trocken zu halten. In einer bevorzugten Ausführung wird die trockenmittelgefüllte Heißschmelzklebemasse auf eine Seite eines Trägermaterials beschichtet und die andere Seite des Trägermaterials mit einem trockenmittelgefüllten Klebstoff beschichtet, der dann in der Anwendung die Verbindung zur Behälterwand herstellt.

US 6,139,935 beschreibt ein sauerstoffabsorbierendes Label, welches an die Innenseite eines Behälters geklebt wird und den Behälterinnenraum von Sauerstoff frei hält.

In DE 199 13 761 A1 werden eine flächenförmige und aktivierbare Trocknungsvorrichtung zur Verringerung des Feuchtigkeitsgehalts eines die Vorrichtung umgebenden Gasraums und ein Herstellungsverfahren für eine solche Vorrichtung beschrieben. Dabei kann das Trockenmittel auch in eine haftklebrige Schicht eingearbeitet sein.

Gegenstand der EP 0 582 968 B1 ist ein Folienverbund mit Wasserdampfsperre, der aus einer ersten Kunststofffolie, einer von einem lösungsmittelhaltigen oder lösungsmittelfreien Kleber oder einem Heißschmelzkleber gebildeten Klebschicht, die 10 bis 50 Gew.% fein verteiltes wasserabsorbierendes Polymerpulver (SAP) enthält, sowie einer über diese Klebschicht mit der ersten Kunststofffolie verbundenen zweiten Kunststofffolie besteht. Ein derartiger Folienverbund wird zur Verpackung feuchtigkeitsempfindlicher Produkte verwendet. Die mit Trockenmittel gefüllte wasserabsorbierende Klebschicht verzögert den Durchtritt von Wasser durch den Folienverbund. Es wird somit im Wesentlichen das Eindringen von Wasser in die Verpackung vermindert.

JP 2001072946 A beschreibt ein Klebeband mit einem Substrat und einer Haftkleberschicht, wobei die Haftkleberschicht ein hygroskopisches Pulver und eine Feuchtigkeit absorbierende Substanz enthält. Beim hygroskopischen Pulver handelt es sich um Hydroxysäure oder deren Salze, die als Härtungsverzögerer für Mörtel oder Beton wirken. Das Trockenmittel soll eine bessere Dispergierbarkeit dieser Verzögerer in der Klebstoffmasse bewirken, also den Verzögerer trocken halten. Mörtel oder Beton, welcher, bedingt durch eine unebene Oberfläche von Kacheln, in den Spalt zwischen Kachel und Klebeband läuft, wird durch den in der Klebemasse enthaltenen Verzögerer am Aushärten gehindert, so dass er nach dem Abziehen des Klebebands leicht von dem hergestellten Kachelverbund abgewischt werden kann.

US 6,112,888 offenbart eine heißschmelzklebende Komposition aus einem Polymer und einem Trockenmittel, welche zum Aufrechterhalten oder Herstellen einer trockenen Packungsatmosphäre verwendet wird. Die Komposition wird aus der Schmelze, z.B. durch Extrusion oder Sprühen, in den Innenraum einer Verpackung appliziert, kann aber auch direkt auf das Füllgut aufgebracht werden.

US 6,936,131 beschreibt ein Verkapselungsverfahren für organische elektronische Aufbauten, bei dem ein Trockenmittel enthaltendes Transferklebeband zum Verbinden von Substrat und Abdeckung verwendet wird. Das Trockenmittel verzögert die Permeation von Wasserdampf durch die Verklebungsfuge zum elektronischen Aufbau.

EP 1 383 182 A2 beschreibt ein System zur Verwendung einer Gas absorbierenden Vorrichtung an der inneren Oberfläche elektronischer Geräte. Das System umfasst obere und untere Schutzschichten, die beide ablösbar und im Wesentlichen gasundurchlässig sind. Die beiden Schutzschichten definieren einen Raum, in dem die absorbierende Vorrichtung platziert ist. Diese umfasst mindestens eine Schicht eines Gettermaterials, die auf Stütz- und Sicherungsmitteln aufgebracht ist, die ihrerseits mindestens eine erste Schicht eines klebenden Materials umfassen, welches geeignet ist, eine Fixierung der absorbierenden Vorrichtung zu bewirken.

WO 2014/001005 A1 hat ein Verfahren zum Schutz einer auf einem Substrat angeordneten elektronischen Anordnung umfassend organische Bestandteile zum Gegenstand, wobei eine Abdeckung derart auf die elektronische Anordnung aufgebracht wird, dass die elektronische Anordnung zumindest teilweise durch die Abdeckung überdeckt wird, wobei die Abdeckung zumindest teilflächig auf dem Substrat und/oder auf der elektronischen Anordnung verklebt wird, wobei die Verklebung mittels zumindest einer Schicht einer Klebemasse in einem Klebeband bewirkt wird und die Klebemasse ein zur Sorption mindestens einer permeationsfahigen Substanz befähigtes Gettermaterial umfasst, wobei das Gettermaterial zu einem Anteil von nicht mehr als 2 Gew.-%, bezogen auf die Klebemasse mit dem Gettermaterial, in der Klebemasse, vorliegt.

EP 2 200 105 A2 offenbart ein Verfahren zur Kapselung einer elektronischen, vorzugsweise optoelektronischen, Anordnung gegen Permeanten, bei dem eine Haftklebemasse auf Basis eines teilkristallinen Polyolefins auf und/oder um die zu kapselnden Bereiche der elektronischen Anordnung appliziert wird, wobei das Polyolefin eine Dichte zwischen 0,86 und 0,89 g/cm und einen Kristallitschmelzpunkt von mindestens 90°C aufweist.

Es ist also im Stand der Technik der Einsatz von Klebebändern zum Trocknen von Gasräumen oder als Permeationsbarriere in Klebefugen bekannt. Darüber hinaus besteht jedoch auch Bedarf an Verfahren zum Trocknen von Flächengebilden.

Flächenförmige Gebilde, insbesondere solche, die in einem kontinuierlichen Prozess bahnförmig hergestellt oder verarbeitet werden, sind aufgrund ihrer oft großen Abmessungen sowie des häufigen Vorliegens in aufgewickelter Form als Rolle schwer permeatfrei, insbesondere trocken, herzustellen oder von Permeat zu befreien. Aufgrund ihres großen Oberfläche/Volumen-Verhältnisses nehmen Sie zudem leicht Permeat aus der Umgebung auf, müssen also vor dem Einbringen in eine permeatfreie Umgebung oder vor einem Kontakt mit permeatempfindlichen Materialien von diesem Permeat wieder befreit werden.

Aufgabe der Erfindung ist es daher, ein einfach durchzuführendes und wirksames Verfahren und eine geeignete Vorrichtung zur Aufnahme von Permeaten aus Flächengebilden zur Verfügung zu stellen.

Der Lösung der Aufgabe liegt der Gedanke zugrunde, dies über ein entsprechend ausgestattetes Klebeband zu realisieren.

Ein erster Gegenstand der Erfindung ist daher ein Verfahren zum Entfernen von zumindest Wasser aus einem Flächengebilde, welches das Aufkleben eines mindestens ein Gettermaterial enthaltenden Klebebandes auf das Flächengebilde,
die Lagerung des derart erhaltenen Verbundes aus Klebeband und Flächengebilde sowie das Entfernen zumindest eines Gettermaterial enthaltenden Teils des Klebebandes von dem Flächengebilde umfasst, wobei das Klebeband zumindest Wasser aus dem Flächengebilde zumindest teilweise aufnehmen kann,
wobei das Gettermaterial ausgewählt ist aus der Gruppe umfassend Barium, Calcium, Calciumsulfat, Calciumchlorid, Calciumoxid, Natriumsulfat, Kaliumcarbonat, Kupfersulfat, Magnesiumperchlorat, Magnesiumsulfat, Lithiumchlorid, Kieselsäuren und Zeolithe sowie Mischungen von zwei oder mehreren der vorstehenden Substanzen..

In einer bevorzugten Ausführungsform umfasst das erfindungsgemäße Verfahren das Entfernen des Klebebandes von dem Flächengebilde, worunter das Entfernen des - im Wesentlichen - gesamten Klebebandes von dem Flächengebilde zu verstehen ist.

Unter einem "Flächengebilde" wird eine flächenförmige Anordnung eines Systems verstanden, dessen Abmessungen in einer Raumrichtung (Dicke oder Höhe) signifikant kleiner sind als in den beiden anderen Raumrichtungen, die die Hauptausdehnung definieren (Länge und Breite). Ein derartiges Flächengebilde kann erfindungsgemäß kompakt oder auch durchbrochen ausgebildet sein und aus einem einzigen Material oder aus unterschiedlichen Materialien bestehen. Ein Flächengebilde kann eine über seine gesamte Flächenausdehnung konstante Dicke aufweisen oder aber unterschiedliche Dicken. Es kann darüber hinaus aus einer einzigen Schicht bestehen oder aus mehreren Schichten, die deckungsgleich oder zumindest teilweise nicht überdeckend angeordnet sein können.

Das Flächengebilde ist beispielsweise eine Folie, insbesondere eine Substrat-, Abdeck- und/oder Verklebungsfolie und/oder eine Trägerfolie, eine Schicht, die auch auf einer Trägerfolie angeordnet und/oder Teil eines Schichtverbunds sein kann, und/oder ein Wirkstoffpflaster.

Unter einem Klebeband wird ein mit mindestens einem Haftklebstoff oder mindestens einem aktivierbaren Klebstoff beschichtetes Trägermaterial beziehungsweise ein als Flächengebilde vorliegender Haftklebstoff oder aktivierbarer Klebstoff von dauerhafter Gestalt verstanden. Ein Klebeband wird seiner Gestalt nach grundsätzlich als ein Flächengebilde angesehen. Bänder mit ausgedehnter Länge und begrenzter Breite, Bandabschnitte, Etiketten, Stanzlinge und dergleichen sind also von der Bezeichnung "Klebeband" mit umfasst. Nicht umfasst sind hingegen ausgehärtete und noch nicht ausgehärtete Flüssigklebstoffe beziehungsweise mit diesen hergestellte Verklebungen.

Bevorzugt ist die auf dem Flächengebilde aufliegende Klebemasse des im erfindungsgemäßen Verfahren eingesetzten Klebebands eine Haftklebemasse oder eine aktivierbare Klebemasse. Besonders bevorzugt ist die auf dem Flächengebilde aufliegende Klebemasse des im erfindungsgemäßen Verfahren eingesetzten Klebebands eine aktivierbare Haftklebemasse. Als Haftklebemassen werden Klebemassen bezeichnet, deren abgebundener Film bei Raumtemperatur in trockenem Zustand permanent klebrig und klebfähig bleibt. Haftklebemassen erlauben bereits unter relativ schwachem Andruck eine dauerhafte Verbindung mit dem Haftgrund.

Allgemein wird zwischen Haftklebemassen für permanente Anwendungen und für reversible Anwendungen (reversibel eingestellte Haftklebemassen) unterschieden. Während sich erstere in der Regel nur mit hohem Kraftaufwand und oft unter Zerstörung des Untergrunds oder des Klebebands selbst wieder ablösen lassen, können letztere mit relativ geringem Kraftaufwand und ohne Zerstörung des Haftgrunds in der Regel vollständig rückstandsfrei wieder abgelöst werden.

Erfindungsgemäß bevorzugt ist die auf dem Flächengebilde aufliegende Klebemasse des im erfindungsgemäßen Verfahren eingesetzten Klebebands reversibel eingestellt.

Die Reversibilität einer Haftklebemasse kann mittels ihrer viskoelastischen Eigenschaften beschrieben werden.

Ein Stoff wird bezüglich seiner viskoelastischen Eigenschaften im Allgemeinen als für Haftklebeanwendungen geeignet angesehen, wenn bei Raumtemperatur im Frequenzbereich von 10° bis 10¹ rad/s, idealerweise im Frequenzbereich von 10⁻¹ bis 10² rad/s, der Speichermodul G' im Bereich von 10³ bis 10⁶ Pa liegt und wenn der Verlustmodul G" ebenfalls in diesem Bereich liegt. Innerhalb dieses Bereiches, den man in einer Matrix-Auftragung aus G' und G" (G' aufgetragen in Abhängigkeit von G") auch als viskoelastisches Fenster für Haftklebeanwendungen oder als Haftklebstofffenster nach viskoelastischen Kriterien bezeichnen kann, gibt es wiederum unterschiedliche Sektoren beziehungsweise Quadranten, die die zu erwartenden Haftklebeeigenschaften der jeweils zugehörigen Stoffe näher charakterisieren. Nach Chang (J. Adhesion, 1991, vol. 34, S. 189-200) sind reversible Haftklebemassen durch G' im Bereich von 10³ - 3x10⁴ Pa und G" im Bereich von 10³ - 3x10⁴ Pa jeweils bei Raumtemperatur und einer Messfrequenz von 10⁻² rad/s charakterisiert.

Speichermodul und Verlustmodul für Haftklebemassen werden hierbei im oszillatorischen Scherexperiment (Dynamisch mechanische Analyse, DMA) unter Torsionsbelastung bei einer Temperatur von 23 °C und einer Frequenz von 0,01 rad/s bestimmt. Der Test dient der Untersuchung rheologischer Eigenschaften und ist in Pahl et al. "Praktische Rheologie der Kunststoffe und Elastomere", VDI-Verlag, 1995, Seite 57 bis 60 sowie 119 bis 127) ausführlich beschrieben. Der Test wird in einem schergeschwindigkeitskontrollierten Rheometer unter Torsionsbelastung gefahren, wobei eine Platte-Platte-Geometrie mit einem Plattendurchmesser von 25 mm verwendet wird.

Erfindungsgemäß bevorzugt wird eine Klebemasse allgemein dann als reversibel eingestellt angesehen, wenn sie eine Klebkraft auf Stahl von < 3 N/cm, bevorzugt von < 2,2 N/cm aufweist.

Erfindungsgemäß können alle dem Fachmann bekannten Haftklebemassen im erfindungsgemäßen Verfahren eingesetzt werden, also beispielsweise solche auf der Basis von Acrylaten und/oder Methacrylaten, Polyurethanen, Naturkautschuken, Synthesekautschuken; Styrolblockcopolymermassen mit einem Elastomerblock aus ungesättigten oder hydrierten Polydienblöcken wie zum Beispiel Polybutadien, Polyisopren, Copolymeren aus beiden, Polybutylen, insbesondere Polyisobutylen, sowie weiteren, dem Fachmann geläufigen Elastomerblöcken; Polyolefinen, insbesondere Poly-α-olefinen und/oder Polyisobutylenen; Fluorpolymeren und/oder Silikonen. Unter den Begriff "Haftklebemasse" fallen auch weitere Massen, die haftklebende Eigenschaften entsprechend dem "Handbook of Pressure Sensitive Adhesive Technology" von Donatas Satas (Satas & Associates, Warwick 1999) besitzen.

Werden im Rahmen dieser Schrift Haftklebemassen auf Acrylatbasis erwähnt, so seien hiervon auch ohne explizite Erwähnung Haftklebemassen auf Basis von Methacrylaten und auf Basis von Acrylaten und Methacrylaten umfasst, sofern nicht ausdrücklich anders beschrieben.

Als aktivierbare Klebemassen werden Klebemassensysteme angesehen, bei denen die Herstellung einer Klebkraft überhaupt bzw. die Erhöhung oder Erniedrigung der Klebkraft durch einen Energieeintrag, zum Beispiel durch aktinische Strahlung oder Wärme, oder eine stoffliche Wechselwirkung erfolgt. Die Aktivierung wird bevorzugt dazu verwendet, eine Reversibilität der Verklebung herzustellen, insbesondere dann, wenn eine Haftklebemasse vor ihrer Aktivierung nicht den reversiblen Haftklebemassen nach Chang zuzuordnen ist. Solche Haftklebemassen sind beispielsweise aus dem Bereich der Grinding- und Dicing-Klebebänder, welche in der Waferbearbeitung eingesetzt werden, bekannt.

Als aktivierbare Klebemasse können grundsätzlich alle üblichen aktiviert verklebenden Klebemassensysteme zum Einsatz gelangen. Die Aktivierung erfolgt erfindungsgemäß bevorzugt in der Regel über einen Energieeintrag, zum Beispiel und besonders bevorzugt durch aktinische Strahlung oder Wärme (hitzeaktiviert verklebende Klebemassen).

Erfindungsgemäß werden auch sogenannte "autoadhäsive" Schichten als reversibel eingestellte Haftklebemassen angesehen. Autoadhäsive Schichten kommen z.B. in Displayschutzfolien zum Einsatz. Sie zeigen nur sehr geringe oder gar keine Anfassklebrigkeit, haften jedoch insbesondere auf sehr glatten Flächen. Autoadhäsive Schichten sind beispielsweise in WO 2005/044560 A1 oder DE 19742805 A1 beschrieben.

Das im erfindungsgemäßen Verfahren eingesetzte Klebeband enthält mindestens ein Gettermaterial. Unter einem "Gettermaterial" wird dabei ein Stoff verstanden, der zur Aufnahme (Sorption) einer oder mehrerer permeationsfähiger Substanz(en) in der Lage ist. Die Sorption der permeationsfähigen Substanz(en) durch das Gettermaterial kann dabei beispielsweise durch Absorption oder Adsorption erfolgen, wobei Adsorption sowohl in Form von Chemisorption als auch von Physisorption auftreten kann. Das Gettermaterial ließe sich daher auch als "Sorbens" oder als "Sorptionsmittel" bezeichnen.

Unter einer "permeationsfähigen Substanz" wird eine Substanz verstanden, die als gasförmiger oder flüssiger, gegebenenfalls auch als fester Stoff, in das Flächengebilde eindringen und dieses nachfolgend durchdringen kann. Derartige Substanzen wurden vorstehend und werden nachstehend auch als "Permeate" bezeichnet. Die Permeate können aus dem Flächengebilde selbst oder aus der Umgebung stammen. Im Flächengebilde selbst enthalten sind häufig niedermolekulare organische Verbindungen wie Lösemittelreste, Restmonomere, Öle, Harzkomponenten, Weichmacher sowie Wasser. Aus der Umgebung stammen oft Wasser, flüchtige organische Verbindungen (VOCs), niedermolekulare Kohlenwasserstoffe und Sauerstoff. Als "permeationsfähige Substanzen" beziehungsweise "Permeate" werden insbesondere die folgenden Substanzen angesehen:
Acetonitril, 1-Butanol, Chlorbenzol, Chloroform (Trichlormethan), Cyclohexan, Diethylether, 1,4-Dioxan, Eisessig (Essigsäure), Essigsäureanhydrid, Essigsäureethylester (Ethylacetat, Essigester), Essigsäure-n-Butylester (n-Butylacetat), Essigsäure-tert.-butylester (t-Butylacetat), Ethanol, Methanol, n-Hexan, n-Heptan, 3-Hexanon, 2-Propanol (Isopropanol), 3-Methyl-1-butanol (Isoamylalkohol), Methylenchlorid (Dichlormethan), Methylethylketon (Butanon), Methylisobutylketon, Nitromethan (Nitrocarbol), n-Pentan, 2-Pentanon, 3-Pentanon, Petrolether (Leichtbenzin), Benzin, Propanol, Pyridin (Azin), tert-Butylmethylether, Tetrachlorethen (Perchlorethen), Tetrahydrofuran, Toluol, Trichlorethan, Triethylamin, Xylol, Sauerstoff, Methan, Ethan, Propan, Propen, Butan, Buten, Kohlenstoffdioxid, Ozon, Schwefeldioxid, Wasser.

Erfindungsgemäß kann im Rahmen des erfindungsgemäßen Verfahrens das Klebeband zumindest Wasser zumindest zum Teil aus dem Flächengebilde aufnehmen.

Die Gettermaterialien werden ihrer Funktion entsprechend bevorzugt als im Wesentlichen von Permeaten freie Materialien eingesetzt, zum Beispiel wasserfrei. Dies unterscheidet Gettermaterialien von ähnlichen Materialien, die als Füllstoff eingesetzt werden. So wird Silica zum Beispiel in Form von pyrogener Kieselsäure häufig als Füllstoff eingesetzt. Wird dieser Füllstoff jedoch wie üblich unter Umgebungsbedingungen gelagert, nimmt er bereits Wasser aus der Umgebung auf und ist nicht mehr in technisch nutzbarem Umfang als Gettermaterial funktionsfähig. Erst getrocknetes oder trocken gehaltenes Silica kann als Gettermaterial genutzt werden. Es ist erfindungsgemäß jedoch auch möglich, bereits teilweise mit Permeaten komplexierte Materialien zu verwenden, beispielsweise CaSO₄*1/2H₂O (Calciumsulfat-Halbhydrat) oder teilhydrierte Kieselsäuren, die per Definition als Verbindungen der allgemeinen Formel (SiO₂)ₘ*nH₂O vorliegen.

Erfindungsgemäß ist das Gettermaterial ausgewählt aus der Gruppe umfassend Barium, Calcium, Calciumsulfat, Calciumchlorid, Calciumoxid, Natriumsulfat,
Kaliumcarbonat, Kupfersulfat, Magnesiumperchlorat, Magnesiumsulfat, Lithiumchlorid, Kieselsäuren und Zeolithe sowie Mischungen von zwei oder mehreren der vorstehenden Substanzen. Diese Gettermaterialien bieten den Vorteil, dass sie sich leicht in die betreffende Schicht des Klebebands einarbeiten lassen, ein hohes Sorptionsvermögen zeigen und regenerierbare Gettermaterialien sind. Darunter werden Substanzen verstanden, die aufgenommene Permeate, beispielsweise Wasser, unter bestimmten Bedingungen wieder abgeben können und dadurch in einen Zustand gelangen, der sie zu erneuter Permeataufnahme befähigt. Dies ermöglicht ein Verfahren, bei dem das Getterhaltige Klebeband vor dem Inkontaktbringen mit dem Flächengebilde von gegebenenfalls bis zu diesem Zeitpunkt aufgenommenen Permeaten weitgehend befreit wird, beispielsweise durch Trocknen. Dadurch steht vorteilhaft bei Verwendung des Klebebands die volle Getterkapazität zur Verfügung.

Insbesondere ist das Gettermaterial ausgewählt aus der Gruppe umfassend Calciumoxid, Calciumsulfat, Calciumchlorid, pyrogene Kieselsäuren und Zeolithe sowie Mischungen von zwei oder mehreren der vorstehenden Substanzen. Diese Materialien weisen besonders hohe Kapazitäten für die Aufnahme von Wasser und weiteren Permeaten auf, sind größtenteils regenerierbar, lassen sich hervorragend in das Klebeband einarbeiten und beeinträchtigen die Funktion der einzelnen Schichten gar nicht beziehungsweise nur in vernachlässigbarer Art und Weise.

Vorteilhaft beträgt der Anteil des Gettermaterials in der das Gettermaterial enthaltenden Schicht des Klebebands jeweils mindestens 1 Gew.-%, bevorzugt mindestens 10 Gew.-%, jeweils bezogen auf das Gewicht der betreffenden Schicht. Der maximale Anteil des Gettermaterials in der das Gettermaterial enthaltenden Schicht des Klebebands ist jeweils nicht begrenzt und kann bis zu einer Schicht aus reinem Gettermaterial reichen.

Der Gehalt hängt wesentlich von der gewünschten Aufnahmekapazität für den/die jeweiligen Permeaten ab.

Wenn zum Beispiel nur eine geringe Aufnahmekapazität erforderlich ist, reicht gegebenenfalls die Verwendung eines Gettermaterials mit geringer Aufnahmekapazität in einem geringen Gehalt aus. In einer bevorzugten Ausführungsform enthält die das Gettermaterial enthaltende Schicht bzw. enthalten die das Gettermaterial enthaltenden Schichten daher jeweils 1 bis 5 Gew.-% Gettermaterial. Ist diese Schicht die Klebemasse des Klebebands, hat dies auch den Vorteil, dass durch den geringen Anteil des Gettermaterials die Klebeigenschaften nicht wesentlich beeinträchtigt werden.

Bei einer sehr hohen erforderlichen Aufnahmekapazität des Klebebands muss jedoch ein relativ hoher Gehalt an Gettermaterial in der das Gettermaterial enthaltenden Schicht verwendet werden, wobei auch das Gettermaterial eine hohe Aufnahmekapazität besitzen sollte. Aber auch ein Gettermaterial mit geringer Aufnahmekapazität kann verwendet werden, wenn dies Kosten- oder Verträglichkeitsaspekte anraten. Im Rahmen einer weiteren bevorzugten Ausführungsform des erfindungsgemäßen Flächengebildes enthält dieses daher 20 bis 99 Gew.-%, bezogen auf das Gesamtgewicht des Klebebands.

Handelt es sich bei der das Gettermaterial enthaltenden Schicht um eine Klebemasse, so ist ein Gehalt von 10 bis 80 Gew.-% bevorzugt, damit ausreichende Klebeigenschaften erhalten bleiben. Soll jedoch die Reversibilität der Klebemasse erhöht oder erst hergestellt werden, ist ein Gehalt von 50 - 95 Gew.-% vorteilhaft, jeweils bezogen auf das Gesamtgewicht der das Gettermaterial enthaltenden Klebemasse.

Bevorzugt weist das Klebeband einen Permeatgehalt von weniger als 1000 ppm, besonders bevorzugt von weniger als 100 ppm auf. Die Angabe ppm bezieht sich dabei auf die Relation des enthaltenen Gesamtgewichts an Permeaten zum Gewicht des Klebebands. Der Permeatgehalt kann mittels der Gaschromatographie nach VDA 277 bestimmt werden oder im Fall von Wasser nach DIN EN ISO 62 (gravimetrisches Verfahren, Methode 4) oder DIN 53715 (Karl-Fischer-Titration) nach Lagerung des Prüflings über 24 Stunden bei 23°C und 50 % relativer Luftfeuchte. Bei geringen Permeatgehalten wird die Kapazität der Gettermaterialien des Klebebands nicht so stark durch aus dem Klebeband selbst diffundierende Permeate beansprucht, und das Klebeband kann seine Funktion als Schutz- bzw. Trocknungsvorrichtung besser erfüllen.

Besonders vorteilhaft weist zumindest eine Schicht des Klebebandes, besonders bevorzugt mindestens eine der äußeren Schichten des Klebebandes, ganz besonders bevorzugt die zur Auflage auf dem Flächengebilde vorgesehene Klebemassenschicht eine geringe Permeationsrate für das zu immobilisierende Permeat auf. Im Fall von Wasserdampf als Permeat beträgt die Wasserdampfpermeationsrate (WVTR) bevorzugt weniger als 50 g/(m²*d), besonders bevorzugt weniger als 20 g/(m²*d), bezogen auf eine Schichtdicke von 50 µm. Die WVTR wird dabei bei 38°C und 90% relativer Luftfeuchtigkeit nach ASTM F-1249, die Sauerstoffpermeationsrate (OTR) bei 23°C und 50% relativer Luftfeuchtigkeit nach DIN 53380-Teil 3 gemessen.

Durch die geringe Permeationsrate diffundiert insbesondere bei der Herstellung des Klebebands weniger Permeat aus der Umgebung durch die betreffende(n) Schicht(en) hindurch in die gettermaterialhaltige Schicht des Klebebands, das somit seine Funktion trotz geringem Gettergehalt länger erfüllen oder mit einer noch geringeren Menge an Gettermaterial ausgerüstet werden kann, was Kosten spart. Besonders bevorzugt weisen daher zumindest die beiden äußeren Schichten des Klebebandes eine geringe Permeationsrate für das zu immobilisierende Permeat auf.

Als (Haft-)Klebemassen mit inhärenter Barrierewirkung, insbesondere als solche (Haft-)Klebemassen, die bei einer Dicke von 50 µm eine Wasserdampfpermeationsrate von weniger als 50 g/(m²*d) und/oder eine Sauerstoffdurchtrittsrate von weniger als 5000 g/(m²*d*bar) aufweisen, lassen sich beispielweise - ohne die Absicht einer Einschränkung auf die genannten Beispiele - solche Klebemassen einsetzen, wie sie in den Schriften DE 102010043871 (A1), DE 102010043866 (A1), DE 102008060113 A1, DE 200810062130 A1, DE 200810047964 A1, DE 200910036970 A1, DE 200910036968 A1, US 20090026934 (A1), EP 1 469 054 B1 und EP 0519278 B2 offenbart werden.

Bevorzugt werden aufgrund der in der Regel relativ geringen Wasserdampfpermeationsrate Klebemassen auf der Basis von Synthesekautschuken eingesetzt, insbesondere auf der Basis von Polyisobutylen und dessen Copolymeren, Polybuten, Butylkautschuk, Styrolblockcopolymeren mit Polymerblöcken gebildet durch Polymerisation von 1,3-Dienen, insbesondere Butadien, Isobutylen und/oder Isopren, welche auch spezifisch oder vollständig hydrierte Polymerblöcke enthalten können, sowie Polyolefinen und deren Copolymeren (siehe auch DE 19742805 A1).

Bevorzugt ist die auf dem Flächengebilde aufliegende Klebemasse des Klebebands frei von Klebharzen. In der Regel wird dadurch die Reversibilität der Verklebung nochmals verbessert.

In einer Ausführungsform der Erfindung weist das Klebeband ein Trägermaterial auf, da hierdurch vorteilhaft die Stanzbarkeit und/oder Applizierbarkeit verbessert wird.

Als Trägermaterial können textile Flächengebilde, Papiere, kunststoffbeschichtete Papiere oder Folien eingesetzt werden, wobei Folien, insbesondere dimensionsstabile Kunststoff- oder Metallfolien, bevorzugt werden. Das Trägerschicht bzw. das Trägermaterial besteht daher bevorzugt aus Polyestern, insbesondere aus Polyethylenterephthalat, zum Beispiel aus biaxial verstrecktem Polyethylenterephthalat; oder aus Polyolefinen, insbesondere aus Polybuten, Cyclo-Olefin-Copolymer, Polymethylpenten, Polypropylen oder Polyethylen, zum Beispiel aus monoaxial verstrecktem Polypropylen, biaxial verstrecktem Polypropylen oder biaxial verstrecktem Polyethylen. Polyesterfolien weisen den Vorteil auf, dass sie für Temperaturstabilität sorgen und eine erhöhte mechanische Stabilität einbringen. Ganz besonders bevorzugt besteht daher die Trägerschicht bzw. das Trägermaterial im erfindungsgemäßen Verfahren eingesetzten Klebebands aus einer Polyesterfolie, beispielsweise aus biaxial verstrecktem Polyethylenterephthalat.

In einer bevorzugten Ausführungsform enthält das Trägermaterial auch eine Barrierefunktion gegen ein oder mehrere spezifische(s) Permeat(e), insbesondere gegen Wasserdampf und Sauerstoff, damit das im Klebeband befindliche Gettermaterial nicht schon während der Herstellung und/oder Lagerung des Klebebands durch aus der Umgebung eindiffundierendes Permeat teilweise oder sogar vollständig abgesättigt wird. Eine derartige Barrierefunktion kann aus organischen oder anorganischen Materialien bestehen. Weiterhin schützt ein solches Trägermaterial im Klebeband das von Permeat zu befreiende Flächengebilde vor dem Eindiffundieren von Permeat aus der Umgebung.

Besonders bevorzugt enthält das Trägermaterial mindestens eine anorganische Barriereschicht. Als anorganische Barriereschichten eignen sich besonders gut im Vakuum (zum Beispiel mittels Verdampfen, CVD, PVD, PECVD) oder unter Atmosphärendruck (zum Beispiel mittels Atmosphärenplasma, reaktiver Coronaentladung oder Flammenpyrolyse) abgeschiedene Metalle, wie Aluminium, Silber, Gold, Nickel oder insbesondere Metallverbindungen wie Metalloxide, -nitride oder -hydronitride, beispielsweise Oxide oder Nitride des Siliziums, des Bors, des Aluminiums, des Zirkoniums, des Hafniums oder des Tellurs oder Indium-Zinn-Oxid (ITO). Ebenfalls geeignet sind mit weiteren Elementen dotierte Schichten der vorstehend genannten Varianten.

Als besonders geeignetes Verfahren zum Aufbringen einer anorganischen Barriereschicht sind High-Power-Impulse-Magnetron-Sputtering und Atomic-Layer-Deposition zu nennen, durch die sich besonders permeationsdichte Schichten bei geringer Temperaturbelastung der Trägerschicht verwirklichen lassen. Bevorzugt wird eine Permeationsbarriere der Trägerschicht mit Barrierefunktion beziehungsweise des Verbundes aus Trägerschicht und Barriereschicht gegen Wasserdampf (WVTR) von < 1 g/(m²*d) und/oder gegen Sauerstoff (OTR) von < 1 cm³/(m²*d*bar), wobei der Wert auf die jeweils im Flächengebilde verwendete Dicke der Trägerschicht bezogen ist, also nicht auf eine spezifische Dicke normiert ist. Die WVTR wird dabei bei 38°C und 90% relativer Luftfeuchtigkeit nach ASTM F-1249 und die OTR bei 23°C und 50% relativer Luftfeuchtigkeit nach DIN 53380-Teil 3 gemessen.

Das erfindungsgemäße Verfahren ist durch das Entfernen zumindest eines Gettermaterial enthaltenden Teils des Klebebandes von dem Flächengebilde gekennzeichnet. Das Gettermaterial kann in der Klebemasse, in der Trägerschicht oder in einer weiteren Schicht des Klebebands enthalten sein oder als eigene Schicht ausgeführt sein. Gettermaterial kann auch in mehreren Teilen des Klebebands enthalten sein. Dabei können gleiche oder auch verschiedene Gettermaterialien eingesetzt werden. Es wird somit auch als erfindungsgemäß angesehen, wenn das Entfernen zumindest eines Gettermaterial enthaltenden Teils des Klebebandes nicht alle Teile des Klebebands umfasst, die Gettermaterial enthalten, und somit der auf dem Flächengebilde verbleibende Teil des Klebebands noch Gettermaterial enthält. In jedem Fall wird ein Teil des im Klebeband enthaltenen Gettermaterials entfernt.

In einer vorteilhaften Ausführung des Verfahrens verbleibt ein Teil des Klebebandes auf dem Flächengebilde. Vorteilhaft ist also die Ausführung des Klebebands als beim Abziehen spaltbares Klebeband, wobei unter spaltbar verstanden wird, dass sich das Klebeband zwischen zwei Schichten innerhalb seines Schichtaufbaus (adhäsives Spalten) oder innerhalb einer Schicht (kohäsives Spalten) auftrennen lässt, wobei die für das Auftrennen erforderliche Kraft unterhalb der Verklebungskraft der Klebemasse auf dem Flächengebilde liegt.

Insbesondere vorteilhaft ist, wenn der verbleibende Teil des Klebebands nach dem Entfernen eines Gettermaterial enthaltenden Teils des Klebebands eine klebfähige Oberfläche aufweist. Dies ist etwa der Fall, wenn nur die Klebemasseschicht auf dem Flächengebilde verbleibt. Eine solche verbleibende klebfähige Oberfläche kann vorteilhaft zum Verbinden des von Permeat befreiten Flächengebildes mit einem Substrat genutzt werden. Sie entsteht beispielsweise dann, wenn ein Gettermaterial enthaltender Releaseliner wie nachstehend beschrieben vom Klebeband abgezogen wird.

Das Klebeband kann mit einem Liner abgedeckt sein. Klebebänder, die ein- oder beidseitig mit Klebstoffen beschichtet sind, werden am Ende des Herstellungsprozesses zumeist zu einer Rolle in Form einer archimedischen Spirale aufgewickelt. Um bei doppelseitig klebenden Klebebändern zu verhindern, dass die Klebemassen miteinander in Kontakt kommen, oder um bei einseitig klebenden Klebebändern eine Verklebung der Klebemasse auf dem Träger zu verhindern, werden die Klebebänder vor dem Wickeln mit einem Abdeckmaterial (auch als Trennmaterial bezeichnet) eingedeckt, das zusammen mit dem Klebeband aufgewickelt wird. Dem Fachmann sind derartige Abdeckmaterialien unter den Namen Liner oder Releaseliner bekannt. Neben der Abdeckung von ein- oder doppelseitig klebenden Klebebändern werden Liner auch zur Eindeckung von reinen Klebemassen (Transferklebeband) und Klebebandabschnitten (zum Beispiel Etiketten) eingesetzt.

Unter einem Liner wird demgemäß ein eine antihaftende (abhäsive) Oberfläche aufweisendes Abdeckmaterial verstanden, das zum temporären Schutz einer Klebemasse direkt auf die Masse aufgebracht wird und in der Regel unmittelbar vor Applikation der Klebemasse durch einfaches Abziehen entfernt werden kann. Vorteilhaft ist ein im erfindungsgemäßen Verfahren eingesetztes Klebeband oder ein hierin offenbartes Klebeband mit einem Releaseliner abgedeckt, der vor der

Durchführung des Verfahrens abgezogen werden kann. Besonders bevorzugt weist der Releaseliner die gleichen Permeationsbarriereeigenschaften auf wie zuvor für das Trägermaterial genannt, damit das im Klebeband befindliche Gettermaterial nicht schon während der Herstellung und/oder Lagerung des Klebebands durch aus der Umgebung eindiffundierendes Permeat teilweise oder vollständig abgesättigt wird.

Der Releaseliner kann auch Gettermaterial enthalten. Der Releaseliner wird in diesem Fall als Bestandteil des Klebebandes angesehen, da er in der Verwendung des Klebebandes im erfindungsgemäßen Verfahren eine Funktion übernimmt. Mit dem Entfernen des Releaseliners würde also ein Gettermaterial enthaltender Teil des Klebebands entfernt.

Die Dicke des im erfindungsgemäßen Verfahren eingesetzten Klebebands kann alle üblichen Dicken umfassen, also etwa von 1 µm bis zu 3000 µm. Bevorzugt wird eine Dicke zwischen 25 und 100 µm, da in diesem Bereich Klebkraft und Handlingeigenschaften besonders positiv ausfallen. Ein weiterer bevorzugter Bereich ist eine Dicke von 3 bis 25 µm, da in diesem Bereich die Gesamtdicke aus dem zu trocknenden / schützenden Flächengebilde und dem Klebeband nicht sehr erhöht wird und der Gesamtaufbau in seiner Flexibilität nur wenig beeinträchtigt wird.

Zur Herstellung eines für das erfindungsgemäße Verfahren eingesetzten Klebebands bzw. eines hierin offenbarten Klebebands wird bevorzugt der Träger des Klebebands oder ein Liner einseitig mit einer bevorzugt gettermaterialhaltigen Klebemasse aus Lösung oder Dispersion oder 100 %ig (zum Beispiel Schmelze) beschichtet oder bedruckt, oder das Klebeband wird durch (Co-)Extrusion hergestellt. Alternativ ist eine Herstellung durch Transfer einer bevorzugt gettermaterialhaltigen Klebemasseschicht durch Kaschieren auf ein Trägermaterial oder einen Liner möglich. Die Klebemasseschicht kann durch Wärme oder energiereiche Strahlen vernetzt werden. In derartigen Prozessen werden vorteilhaft auch Aufbauten hergestellt, bei denen das Gettermaterial in einer anderen Schicht als der Klebemasse vorhanden ist.

Die Schicht, welche das Gettermaterial enthält, kann grundsätzlich direkt mittels dem Fachmann bekannter Verfahren aus der Lösung, Emulsion oder Dispersion aufgebracht werden. Das verwendete Löse-, Emulsions- beziehungsweise Dispergiermittel kann in diesem Fall anschließend in einem handelsüblichen Trockner verdampft werden. Ebenso ist eine lösungsmittelfreie Beschichtung, z.B. mittels Streu, Beflockungs- oder Bepuderungsverfahren, geeignet.

Die Schicht, welche das Gettermaterial enthält, kann erfindungsgemäß auch gedruckt werden. Hierzu eignen sich nach dem Stand der Technik Tief- und Siebdruckverfahren. Bevorzugt werden hier rotative Druckverfahren angewendet. Ferner können Beschichtungen auch durch Aufsprühen aufgebracht werden. Dies kann im rotativen Sprühverfahren geschehen, gegebenenfalls auch elektrostatisch.

Bevorzugt findet dieser Herstellprozess in einer Umgebung statt, in der das spezifische Permeat nur in geringer Konzentration oder nahezu gar nicht enthalten ist. Als Beispiel kann eine relative Luftfeuchtigkeit von weniger als 30 %, bevorzugt von weniger als 15 %, genannt werden.

Zur Optimierung der Eigenschaften kann die zum Einsatz kommende Klebemasse mit einem oder mehreren Additiven wie Klebrigmachern (Harzen), Weichmachern, Füllstoffen, Pigmenten, UV-Absorbern, Lichtschutzmitteln, Alterungsschutzmitteln, Vernetzungsmitteln, Vernetzungspromotoren und/oder Elastomeren abgemischt sein.

Die Menge einer Klebstoffschicht im Klebeband beträgt bevorzugt 1 bis 200 g/m², vorzugsweise 10 bis 100 g/m², wobei unter "Menge" die Menge nach einer eventuell durchgeführten Entfernung von Wasser oder Lösungsmittel verstanden wird.

Bevorzugten Einsatz findet das erfindungsgemäße Verfahren beim Entfernen von Permeaten aus Einsatzmaterialien oder Zwischenprodukten in der Fertigung von organischen elektronischen Aufbauten, insbesondere/beispielsweise aus Substrat- oder Abdeckmaterialien, aus insbesondere gedruckten Anoden oder Kathoden, insbesondere gedruckten leitfähigen Schichten oder Leiterbahnen, Lochinjektionsschichten (Holeinjection-layers (HIL), insbesondere solchen auf der Basis wässriger Dispersionen von intrinsisch leitfähigen Polymeren wie z.B. PEDOT:PSS, sowie aus insbesondere gedruckten organischen lichtemittierenden oder-absorbierenden Schichten, insbesondere LITI-Folien, und aus Wirkstoffpflastern.

Besonders bevorzugt wird das erfindungsgemäße Verfahren zum Entfernen von Permeaten aus Substrat- oder Abdeckfolien, aus Lochinjektionsschichten sowie aus organischen lichtemittierenden oder -absorbierenden Schichten eingesetzt.

Hierin offenbart wird auch ein Klebeband, das eine Trägerschicht mit einer Wasserdampfpermeationsrate von < 1 g/(m²*d) (gemessen nach ASTM F-1249 bei 38°C und 90% relativer Luftfeuchtigkeit), eine Klebemasse und mindestens ein in einer zwischen Trägerschicht und Klebemasse angeordneten Schicht oder in der Klebemasse enthaltenes, zur Sorption mindestens einer permeationsfähigen Substanz befähigtes Gettermaterial umfasst und das dadurch gekennzeichnet ist, dass die Klebemasse reversibel eingestellt ist. Mit einem derartigen Klebeband lässt sich besonders effizient Permeat aus einem Flächengebilde entfernen und gleichzeitig die Aufnahme von Permeaten, insbesondere von Wasser aus der umgebenden Atmosphäre verhindern. Bevorzugt ist das Gettermaterial in einer zwischen Trägerschicht und Klebemasse angeordneten Schicht enthalten.

Bereits im Rahmen der Beschreibung des erfindungsgemäßen Verfahrens offenbarte Ausführungsformen des dort eingesetzten Klebebands gelten selbstverständlich auch für das hier offenbarte Klebeband, sofern sie zu diesem nicht in Widerspruch stehen. Insbesondere ist die Klebemasse des offenbarten Klebebandes daher eine reversibel eingestellte Klebemasse. Andersherum stellen Ausführungsformen des offenbarten Klebebands gleichzeitig auch mögliche Ausführungsformen im erfindungsgemäßen Verfahren einsetzbarer Klebebänder dar.

Sofern das Gettermaterial in einer zwischen Trägerschicht und Klebemasse angeordneten Schicht vorliegt, kann diese Schicht das Gettermaterial in einer Matrix enthalten, beispielsweise als disperses Material. Die Schicht kann aber auch von dem Gettermaterial selbst gebildet werden und somit aus diesem bestehen. Auch kann die Trägerschicht das Gettermaterial enthalten oder von diesem selbst gebildet werden.

In einer Ausführungsform des offenbarten Klebebands ist das Gettermaterial in einer zwischen Trägerschicht und Klebemasse angeordneten Schicht und/oder in der Klebemasse als dispergierte Phase enthalten. Unter "als dispergierte Phase enthalten" wird verstanden, dass das Gettermaterial fein verteilt in der/den betreffenden Schicht(en) des Klebebands vorliegt. Grundsätzlich sind Form und Größe der Gettermaterial-Teilchen - selbstverständlich innerhalb der sich aus dem Aufbau und der Funktion des Klebebands bzw. der Schichten ergebenden Limitierungen - keine Grenzen gesetzt. Das Merkmal "als dispergierte Phase enthalten" schließt eine molare Dispersion und damit eine echte (molekulare) Lösung des Gettermaterials in dem Material der betreffenden Schicht ebenso ein wie eine Dispersion von Gettermaterial-Primärteilchen, Gettermaterial-Aggregaten und Gettermaterial-Agglomeraten.
Bevorzugt ist das Gettermaterial in der Klebemasse als dispergierte Phase enthalten.

Das Merkmal "als dispergierte Phase enthalten" bedeutet darüber hinaus, dass das betreffende Gettermaterial keine eigenständige, durchgehende Schicht bildet, sondern generell in Form mehrerer, verteilter Teilchen vorliegt. Es bedeutet hingegen nicht, dass eine ideale oder statistische Verteilung der Gettermaterial-Teilchen im Schichtmaterial vorliegen muss. Die Gettermaterial-Teilchen können sich zum Beispiel durchaus in bestimmten Bereichen innerhalb der Schicht konzentrieren bzw. können bestimmte Bereiche einer Getter-haltigen Schicht des Liners auch frei von Gettermaterial sein.
Die Verteilung des Gettermaterials als dispergierte Phase in einer Schicht des Klebebands weist gegenüber einer durchgehenden, eigenständigen Gettermaterial-Schicht den Vorteil auf, dass die spezifische Oberfläche zur Aufnahme von Permeaten größer ist als im Falle einer durchgehenden Schicht und somit höhere Aufnahmekapazitäten für Permeate realisiert werden können.

Grundsätzlich ist die Größe der Partikel des Gettermaterials durch die Anforderungen der Dicke der diese jeweils enthaltenden Schicht begrenzt. Als eine obere Grenze für die Größe der Partikel können daher etwa 200 µm angesehen werden, bevorzugt wird aber Gettermaterial in Form von Teilchen mit einer Korngröße von maximal 50 µm verwendet.

Im offenbarten Klebeband können durchaus mehrere Schichten, beispielsweise eine Trägerschicht und die Klebeschicht und gegebenenfalls auch noch weitere Schichten das gleiche oder auch verschiedene Gettermaterial(ien) enthalten.

Vorzugsweise liegt das Gettermaterial in Form von Partikeln in einer Partikelgrößenverteilung vor, bei der maximal 1 Vol.-% des Gettermaterials die mittlere Schichtdicke der gettermaterialhaltigen Schicht überschreitet. Dies hat den Vorteil, dass die Getterpartikel nicht aus der jeweiligen Schicht herausragen und damit die Oberflächeneigenschaften stark negativ beeinflussen. In einer besonders bevorzugten Ausführungsform liegt das gesamte im offenbarten Klebeband enthaltene Gettermaterial in einer Partikelgrößenverteilung vor, bei der maximal 1 Vol.-% des Gettermaterials die mittlere Schichtdicke der jeweiligen gettermaterialhaltigen Schicht überschreitet.

In einer alternativen bevorzugten Variante liegt das Gettermaterial in Form von Partikeln in einer Partikelgrößenverteilung vor, bei der zumindest 10 Vol.-% die mittlere Schichtdicke der gettermaterialhaltigen Schicht überschreiten. Dies führt zu einer rauen Oberfläche und kann die Verankerung der verschiedenen Schichten im Schichtverbund des Klebebands verbessern oder die Reversibilität auf dem Flächengebilde erhöhen. Sind diese Partikel in der mit dem Flächengebilde in Kontakt stehenden Klebeschicht angeordnet, so sind sie in geringerem Maße mit der Klebemasse überdeckt, haben so nahezu unmittelbaren Kontakt zum Flächengebilde und können so noch effizienter Permeate binden. Besonders bevorzugt liegt das gesamte im offenbarten Klebeband enthaltene Gettermaterial in einer Partikelgrößenverteilung vor, bei der zumindest 10 Vol.-% die mittlere Schichtdicke der jeweiligen gettermaterialhaltigen Schicht überschreiten.

Unter "Partikeln" werden im Sinne von DIN 53206-1: 1972-08 Primärteilchen, Aggregate und Agglomerate des Gettermaterials beziehungsweise der Gettermaterialien verstanden. Unter der "Partikelgröße" wird die maximale Ausdehnung eines Partikels verstanden. Die Bestimmung der Partikelgröße erfolgt bevorzugt mittels Laserbeugung nach ISO 13320 (wobei im Dispersionsschritt Agglomerate dispergiert werden, nicht jedoch Aggregate), aber auch andere dem Fachmann bekannte Verfahren sind geeignet.

Besonders bevorzugt liegen alle Gettermaterialien nanoskalig vor, das heißt die maximale Ausdehnung in mindestens einer Dimension beträgt weniger als 500 nm, ganz besonders bevorzugt weniger als 200 nm, beispielsweise weniger als 100 nm.

Solche Gettermaterialien können beispielsweise dispergiertes pyrogenes Silica wie Aerosil der Firma Evonik, Calcium Oxide Nanopowder der Firma Sigma-Aldrich, Calciumchlorid CA-CI-02-NP der Firma American Elements (Los Angeles), Nanozeolith LTA oder FAU der Firma Nanoscape (Planegg-Martinsried) oder nanoskaliges Zeolith Lucidot NCL 40 der Firma Clariant (Frankfurt) sein.

In einer weiteren Ausführungsform umfasst das offenbarte Klebeband mindestens eine zwischen Trägerschicht und Klebemasse angeordnete Schicht eines Gettermaterials.

Die Gettermaterialschicht ist vorzugsweise als zusammenhängende, durchgehende und ununterbrochene Schicht ausgebildet. Sie kann jedoch auch als unterbrochene Schicht vorliegen oder auch Löcher aufweisen. Offenbarungsgemäß ist es möglich, eine vollflächige oder durchbrochene Schicht pulverförmigen Gettermaterials auf eine weitere im Aufbau des Klebebandes vorgesehene Schicht, beispielsweise auf ein Trägermaterial, aufzubringen und, zum Beispiel durch einen thermischen und/oder mechanischen Prozess wie Heißwalzen, mit dem Schichtmaterial zu binden. Eine durchbrochene Schicht hat den Vorteil, dass zugelassene Permeate die Schicht leichter passieren können, zu bindende Permeate aber abgefangen werden. Weiterhin weist eine zum Beispiel aus Partikeln bestehende durchbrochene Schicht eine höhere Oberfläche auf als eine vollflächige, glatte Schicht, so dass die Sorptionsfähigkeit des Gettermaterials noch besser zum Tragen kommt.

Die Dicke der Gettermaterial-Schicht hängt insbesondere von der gewünschten Aufnahmekapazität für den jeweiligen Permeaten ab. Als Untergrenze ist die minimale Dicke einer durchgängigen Schicht eines hoch aufnahmefähigen Gettermaterials, zum Beispiel einer Calciumschicht, anzusehen, welche mit etwa 20 nm beziffert werden kann. Als Obergrenze ist die Dicke einer aus metallischem Gettermaterial, beispielsweise aus einer Barium-Zink-Legierung, bestehenden Folie anzusehen, welche in ihrer Steifigkeit das Aufwickeln eines Klebebands noch erlaubt. Eine derartige Schichtdicke kann mit etwa 100 µm beziffert werden.

Die Gettermaterial-Schicht ist bevorzugt aus dem reinen Gettermaterial ausgeführt. Beispielsweise handelt es sich dabei um eine aufgedampfte oder gesputterte Schicht eines Gettermaterials. In einer weiteren Ausführungsform liegt mindestens ein weiteres Material in der Getterschicht dispergiert vor. Beispielsweise ist dieses weitere Material ein Gas, so dass die Getterschicht besonders vorteilhaft als Schaum, insbesondere als offenzelliger Schaum, vorliegt. Dies hat den Vorteil einer besonders großen aktiven Oberfläche der Getterschicht. Auch Materialien in festem oder flüssigem Zustand können in der Gettermaterialschicht dispergiert vorliegen. Dies können zum Beispiel Materialien sein, die ein sich unter Permeataufnahme verflüssigendes Gettermaterial, beispielsweise Lithiumchlorid, oder freiwerdende Gase, beispielsweise Wasserstoff bei der Reaktion von Barium mit Wasser, binden. Auch Porenbildner, die nach der Ausbildung der Gettermaterialschicht wieder entfernt werden, können das in der Getterschicht dispergierte Material bilden. Dies können zum Beispiel organische Materialien sein, die bei einer elektrochemischen Abscheidung einer Gettermaterialschicht zunächst eingebaut werden, in einem nachfolgenden Schritt aber wieder herausgelöst werden, und so eine poröse Gettermaterialstruktur hinterlassen.

Ein Gettermaterial, das dispergiert (als dispergierte Phase) in einer Schicht des Klebebands vorliegt, stellt keine "Schicht eines Gettermaterials" im Sinne der Offenbarung dar. Eine offenbarungsgemäße "Schicht eines Gettermaterials" liegt nur dann vor, wenn die Schicht im Wesentlichen von dem Gettermaterial selbst gebildet wird, beispielsweise als ausschließliches Material der Schicht oder als kontinuierliche Phase einer Dispersion. Als kontinuierliche Phase einer Dispersion gelten im Sinne der Erfindung auch perkolierte Partikel. Unter "perkolierten Partikeln" werden Partikel verstanden, die miteinander derart in Wechselwirkung stehen, dass sie zusammenhängende Gebiete beziehungsweise Cluster bilden. Da das Vorliegen einer Perkolation nicht unmittelbar zu erfassen ist, wird hilfsweise ein Gewichtsanteil des Gettermaterials von 50 % innerhalb einer Dispersion als Perkolationsschwelle definiert.

Vorteilhaft ist die zum Aufliegen auf dem Flächengebilde vorgesehene Klebemasse des offenbarten Klebebands vor der Applikation mit einem Liner abgedeckt. Besonders bevorzugt enthält der Liner auch eine Barrierefunktion gegen ein oder mehrere spezifische(s) Permeat(e), insbesondere gegen Wasserdampf und Sauerstoff, damit das im Klebeband befindliche Gettermaterial nicht während der Herstellung und/oder Lagerung des Klebebands durch aus der Umgebung eindiffundierendes Permeat schon teilweise oder vollständig abgesättigt wird. Eine derartige Barrierefunktion kann aus organischen oder anorganischen Materialien bestehen. Bevorzugt wird eine Permeationsbarriere der Trägerschicht des Liners mit Barrierefunktion beziehungsweise des Verbundes aus Trägerschicht und Barriereschicht des Liners gegen Wasserdampf (WVTR) von < 1 g/(m²*d) und/oder gegen Sauerstoff (OTR) von < 1 cm³/(m²*d*bar), wobei der Wert auf die jeweils im Liner verwendete Dicke der Trägerschicht bezogen ist, also nicht auf eine spezifische Dicke normiert ist. Die WVTR wird dabei bei 38°C und 90% relativer Luftfeuchtigkeit nach ASTM F-1249 und die OTR bei 23°C und 50% relativer Luftfeuchtigkeit nach DIN 53380-Teil 3 gemessen.

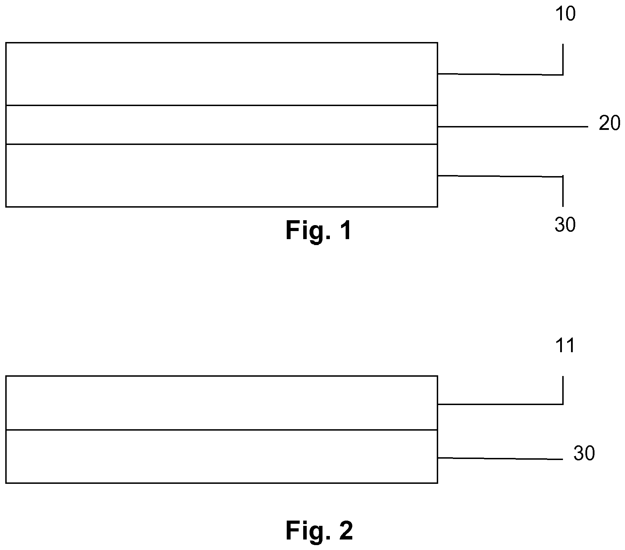

Mögliche Ausführungsformen eines offenbarten Klebebands sind in den Figuren 1 und 2 dargestellt. Darin bedeuten:
Fig. 1:
   10: reversible Klebemasse
   20: Schicht enthaltend Gettermaterial
   30: Trägermaterial mit WVTR < 1 g/m²d bei 38°C und 90 % rF bezogen auf die eingesetzte Trägermaterialdicke
Fig. 2:
   11: reversible Klebemasse enthaltend Gettermaterial, wobei die Klebemasse eine geringe Permeationsrate für das zu immobilisierende Permeat aufweist.
   30: Trägermaterial mit WVTR < 1 g/m²d bei 38°C und 90 % rF bezogen auf die eingesetzte Trägermaterialdicke.

Offenbart wird auch die Verwendung eines offenbarungsgemäßen Klebebands zum Entfernen von Permeaten aus einem Flächengebilde, bevorzugt zum zumindest teilweisen Entfernen von zumindest Wasser aus einem Flächengebilde.

### Beispielteil

Es wurden verschiedene mit Gettermaterial gefüllte Klebebänder zur Durchführung des Verfahrens hergestellt.

### Klebemasseschichten:

Zur Herstellung von Klebemasseschichten wurden verschiedene Klebemassen aus einer Lösung auf einen konventionellen Liner des Typs Silphan S75 M371 der Firma Siliconature mittels eines Laborstreichgeräts aufgebracht und getrocknet. Die Klebemassenschichtdicke nach dem Trocknen ist jeweils angegeben. Die Trocknung erfolgte jeweils bei 120 °C über 30 min in einem Labortrockenschrank.
K1 Haftklebemasse

| | | |
|---|---|---|
| 100 Teile | Tuftec P 1500 | SBBS mit 30 Gew.-% Blockpolystyrolgehalt der Firma Asahi. Das SBBS enthält ca. 68 Gew.-% Zweiblockgehalt. |
| 100 Teile | Escorez 5600 | Hydriertes KW-Harz mit einem Erweichungspunkt von 100 °C der Firma Exxon |
| 25 Teile | Ondina 917 | Weißöl aus paraffinischen und naphthenischen Anteilen der Firma Shell |

Als Lösungsmittel wurde ein Gemisch aus Toluol und Aceton im Verhältnis 2:1 verwendet.
K2: reversible Haftklebemasse

| | | |
|---|---|---|
| 90 Teile | Butyl 100 | Butylkautschuk von Bayer, Isoprengehalt 0,9 Mol-% |
| 10 Teile | Hyvis 200 | Polybuten von BP Chemical |

Als Lösungsmittel wurde Siedegrenzbenzin verwendet.
K3: reversible Haftklebemasse

| | | |
|---|---|---|
| 80 Teile | Butyl 100 | Butylkautschuk von Lanxess, Isoprengehalt 0,9 Mol-% |
| 10 Teile | Oppanol B 150 | Polyisobutylen (PIB) von BASF, Mn = 425.000 g/mol |
| 10 Teile | Regalite R 1100 | Hydriertes Kohlenwasserstoffharz der Fa. Eastman mit einem Erweichungspunkt von 100 °C |

Als Lösungsmittel wurde Siedegrenzbenzin verwendet.
K4: reversible Haftklebemasse

| | | |
|---|---|---|
| 100 Teile | Levapren 700 | Polyethylenvinylacetat, Hersteller Bayer, Anteil Vinylacetat 70 Gew.-%. |
| 30 Teile | Levapren 800 | Polyethylenvinylacetat, Hersteller Bayer, Anteil Vinylacetat 80 Gew.-%. |
| 25 Teile | Levapren 450 | Polyethylenvinylacetat, Hersteller Bayer, Anteil Vinylacetat 45 Gew.-%. |

Als Lösemittel wurde Methylethylketon verwendet.
K5: strahlenaktiviert reversible Haftklebemasse

| | | |
|---|---|---|
| 59 Teile | | Acrylatcopolymer bestehend aus 56 Gew.-% Butylacrylat, 40 Gew-% Methylacrylat, 2 Gew.-% Acrylsäure und 2 Gew.-% Benzoinacrylat, hergestellt in radikalischer Polymerisation nach dem in DE 195 20 238 C2 offengelegten Verfahren (Beispiel 1) |
| 0,4 Teile | Aluminium-Acetylacetonat | |
| 28 Teile | Ebecryl 220 | hexafunktionelles, aromatisches Urethan-Acrylat-Oligomer der Firma Cytec |
| 12 Teile | PETIA | Pentaerythritoltri-tetraacrylat der Firma Cytec mit einem tri/tetra-Verhältnis von etwa 1:1 |

K6: reversible Haftklebemasse

| | | |
|---|---|---|
| 85 Teile | Oppanol B 150 | PIB von BASF, Mn = 425.000 g/mol |
| 15 Teile | Oppanol B 50 | PIB von BASF, Mn = 120.000 g/mol |

Als Lösungsmittel wurde Siedegrenzbenzin verwendet.

Speichermodul und Verlustmodul der reversiblen Haftklebemassen wurden im oszillatorischen Scherexperiment (Dynamisch mechanische Analyse, DMA) unter Torsionsbelastung bei einer Temperatur von 23 °C und einer Frequenz von 0,01 rad/s bestimmt.

Weiterhin wurde die Wasserdampfpermeationsrate (WVTR) bei 38°C und 90% relativer Luftfeuchtigkeit nach ASTM F-1249 gemessen. Der angegebene Wert ist der Mittelwert aus zwei Messungen.

Die Klebkräfte auf Stahl wurden analog ISO 29862 (Methode 3) bei 23 °C und 50 % relativer Luftfeuchte bei einer Abzugsgeschwindigkeit von 300 mm/min und einem Abzugswinkel von 180° bestimmt. Als Verstärkungsfolie wurde eine geätzte PET-Folie mit einer Dicke von 50 µm verwendet, wie sie von der Fa. Coveme (Italien) erhältlich ist. Die Verklebung des Messstreifens wurde dabei mittels einer Anrollmaschine bei einer Temperatur von 23 °C vorgenommen. Die Klebebänder wurden sofort nach der Applikation abgezogen. Der angegebene Wert ist der Mittelwert aus drei Messungen.

| Bezeichnung | WVTR [g/m² d] | Klebkraft/Stahl [N/cm] |
|---|---|---|
| K1 (nicht reversibel) | 68 | 7,1 |
| K2 | 44 | 1,7 |
| K3 | 18 | 2,2 |
| K4 | 155 | 1,2 |
| K5 | 569 | 1,8 vor / 0,23 nach UV |
| K6 | 6 | 1,0 |

Die ermittelten Klebkräfte auf Stahl zeigen, dass es sich bei den Massen K2 - K6 um reversible Haftklebemassen handelt.

Als Trägermaterial für die Klebebänder wurde ein Laminat aus Aluminiumfolie und BOPP der Firma Novelis, Berlin, verwendet. Die Klebemasse wurde auf die Aluminiumseite des Verbundträgers aus der Lösung beschichtet und getrocknet.

Folgende Gettermaterialien wurden verwendet:

| Bezeichnung | Beschreibung | Handelsname | Lieferant |
|---|---|---|---|
| G1 | Calciumoxid | Calcium oxide nanopowder | Sigma-Aldrich |
| G2 | Zeolith 3A | Purmol 3 STH | Zeochem |

Die Gettermaterialien wurden mittels einer schnelllaufenden Dispergierscheibe eines Laborrührwerks in die Klebemasselösungen eingearbeitet. Die Klebemasselösungen wurden zuvor mittels ca. 1 mm großer Zeolithkugeln getrocknet, welche vor dem Beschichtungsprozess wieder ausgefiltert wurden.

Tabelle 1 zeigt die hergestellten Gettermaterial-haltigen Klebebänder nach Fig. 2 im Überblick (T1 - T11, T13, T14). Die Klebemassen K1, K4 und K5 weisen dabei entgegen der Beschreibung zu Fig. 2 eine WVTR von mehr als 50 g/(m²*d) auf. Lediglich Klebeband 12 (T12) wurde nach Fig. 1 hergestellt, wobei das Gettermaterial in Klebemasse 1 dispergiert und als "Schicht enthaltend Gettermaterial (20)" in einer Dicke von 50 µm verwendet wurde. Als Klebemasse (10) wurde Klebemasse 4 verwendet.

**Tabelle 1: Gettermaterial-gefüllte Klebebänder:**

| Bezeichnung | Klebemasse | Getter-material | Anteil Getter [Gew.-%] | Dicke Klebemasseschicht [µm] |
|---|---|---|---|---|
| T1 | K2 | G1 | 10 | 75 |
| T2 | K2 | G1 | 20 | 75 |
| T3 | K2 | G1 | 40 | 75 |
| T4 | K3 | G1 | 20 | 75 |
| T5 | K4 | G1 | 20 | 75 |
| T6 | K5 | G1 | 20 | 50 |
| T7 | K2 | G2 | 20 | 75 |
| T8 | K2 | G2 | 40 | 75 |
| T9 | K3 | G2 | 20 | 75 |
| T10 | K4 | G2 | 20 | 75 |
| T11 | K5 | G2 | 20 | 50 |
| T12 | K1 / K4 | G2 in K1 | 20 | K1: 50 ; K2: 20 |
| T13 | K1 | G2 | 20 | 75 |
| T14 | K6 | G2 | 20 | 50 |

Als weiteres Gettermaterial-gefülltes Klebeband wurde die Klebemasse K1, enthaltend kein Gettermaterial, in einer Trockenschichtdicke von 50 µm mit einem Gettermaterialhaltigen Liner ausgerüstet.

Zur Herstellung dieses Liners wurde mittels eines Laborlaminiergeräts eine Klebemasseseite des Klebebandes T13 mit einem konventionellen Liner auf dessen nicht trennende Seite laminiert und die andere Klebemasseseite mit einer BOPP-Folie abgedeckt. Es wurde dabei der konventionelle Liner des Typs SILPHAN S36 M372 (36 µm PET), erhältlich von der Firma Siliconature, Italien, verwendet. Als Abdeckung wurde eine BOPP-Folie mit einer Dicke von 36 µm der Firma Pao-Yan, Taiwan, verwendet.

Der auf diese Weise erhaltene Gettermaterial-haltige Liner wurde auf die kein Gettermaterial enthaltende Klebemasse K1 aufgebracht. Dieses Klebeband wird im Folgenden als T15 bezeichnet.

Als von Permeat zu befreiendes Flächengebilde wurde eine circa 30 µm dicke, mit einer anorganischen Barriereschicht beschichtete Polyesterfolie (GX-P-F der Firma Toppan Printing) verwendet. Die Folie wurde vor der Verwendung 24 Stunden bei 23 °C und 50 % rF konditioniert.

Die hergestellten gettermaterialhaltigen Klebebänder wurden nach dem Trocknen unverzüglich auf die nicht anorganisch beschichtete Seite der Polyesterfolie laminiert. Mit den Klebebändern T11 und T14 wurde zusätzlich der Versuch unternommen, die Klebebänder zunächst 1 Stunde bei 23°C und 50 % rF offen zu lagern und erst dann auf die Polyesterfolie zu laminieren.

Die so hergestellten Verbunde wurden über 14 Tage bei 23 °C in einer permeationsdichten Verpackung (eingeschweißt in einer Aluminiumverbundfolie) gelagert. Die Muster wurden dann in einer Glovebox (Atmosphäre: Wasserdampf < 5 ppm, Sauerstoff < 1 ppm) ihrer Verpackung entnommen und es wurde jeweils das Klebeband von der Polyesterfolie abgezogen. Die Polyesterfolie wurde unverzüglich zur Wassergehaltsbestimmung in Glasbehälter eingesiegelt. Muster mit der Klebemasse K5 wurden zuvor in der Glovebox mit einem UV-Cube der Fa. Hoenle mit einer UV-C-Dosis von 80 mJ/cm² (250 - 260 nm-Band) vernetzt, um die Reversibilität herzustellen. Bei Mustern mit dem Klebeband T15 wurde nur der Gettermaterial-haltige Liner entfernt und der Wassergehalt des verbliebenen Verbundes aus Klebemasse K1 und Polyesterfolie bestimmt.

### Messung des Wassergehalts

Der Wassergehalt wurde ermittelt nach DIN 53715 (Karl-Fischer-Titration). Die Messung erfolgte an einem Karl-Fischer Coulometer 851 in Verbindung mit einem Ovensampler (Ofentemperatur 140 °C). Mit einer Einwaage von ca. 0,3 g wurde jeweils eine Dreifachbestimmung durchgeführt. Als Wassergehalt wird der arithmetische Mittelwert der Messungen angegeben.

Weiterhin wurde die Reversibilität der Klebemassen subjektiv beim Ablösen des Klebebands von der Barrierefolie beurteilt.

Tabelle 2 stellt die Ergebnisse dar:

**Tabelle 2: Ergebnisse des Trocknungsverfahrens und Reversibilität**

| Bezeichnung des applizierten und wieder entfernten Tapes | Wassergehalt Flächengebilde [ppm] | Reversibilität ++ sehr leicht ablösbar + leicht ablösbar o mit etwas Kraft ablösbar - mit hoher Kraft ablösbar |
|---|---|---|
| - (konditionierte Folie) | 3630 | n.a. |
| T1 | 57 | + |
| T2 | 7 | + |
| T3 | < 2* | ++ |
| T4 | 10 | + |
| T5 | 4 | + |
| T6 | 23 | ++ |
| T7 | 12 | + |
| T8 | < 2* | ++ |
| T9 | 9 | + |
| T10 | 7 | + |
| T11 | 4 | ++ |
| T12 | 7 | + |
| T13 | 10 | - |
| T14 | 13 | ++ |
| T15 | 13 | nur Liner abgelöst |
| T11 - 1 h konditioniert | 1540 | ++ |
| T14 - 1 h konditioniert | 22 | ++ |

| | | |
|---|---|---|
| * Messgrenze | | |

Die Ergebnisse zeigen, dass mit dem erfindungsgemäßen Verfahren hervorragende Trocknungsergebnisse erzielt werden können.

Überraschend zeigen die mit einem Klebeband mit reversibler Klebemasse durchgeführten Versuche (T1 - T12, T14) keine schlechtere Befreiung vom Permeat als das Beispiel mit einer konventionellen Klebemasse (T13), obwohl der Fachmann erwartet hätte, dass eine reversible Klebemasse aufgrund der geringeren Fließfähigkeit einen geringeren Kontakt zum Verklebungssubstrat aufbaut und somit der Stofftransport vermindert wird.

Beide verwendeten Gettermaterialien erweisen sich als gut geeignet. Überraschend zeigen auch Versuche mit einem geringen Anteil an Gettermaterial im Klebeband (T2, T7) eine im Vergleich zu solchen mit höherem Füllgrad (T3, T8) nur gering verminderte Wirksamkeit.

Überraschend zeigt auch ein Klebeband mit dem Aufbau nach Figur 1 (T12), bei dem der Stofftransport zunächst durch eine wenig permeable Schicht erfolgen muss, keine nennenswert schlechteren Eigenschaften. Dies gilt auch für die Ausführung des Klebebands mit einem Gettermaterial-haltigen Liner (T15), bei dem das Permeat zunächst die Trägerfolie des Liners passieren muss. Nach dem Abziehen des Liners sind sowohl Klebemasse wie auch Flächengebilde getrocknet. Das Flächengebilde kann aufgrund der haften gebliebenen Klebemasse verklebt werden, ohne dass wie in den weiteren Beispielen eine weitere Klebemasse auf das Flächengebilde appliziert werden muss. Beispielsweise kann ein solches Flächengebilde aus einer getrockneten Barrierefolie mit einer ebenfalls trockenen Haftklebemasse wie in Beispiel T15 vorteilhaft zur Verkapselung einer organischen elektronischen Anordnung verwendet werden.

Im Vergleich der Verfahren mit den Klebebändern T11 und T 14, die sofort oder nach einstündiger Konditionierung auf das Barrieresubstrat laminiert wurden, zeigt sich der Vorteil einer Klebemasse mit einer geringen Permeationsrate: T11 zeigt nach der Konditionierung eine wesentliche Verringerung der Trocknungsleistung, während das Klebeband T14 mit der wesentlich weniger permeablen Klebemasse kaum einen Abfall der Trocknungsleistung zeigt.

## Patentansprüche

1. Verfahren zum Entfernen von zumindest Wasser aus einem Flächengebilde, umfassend das Aufkleben eines mindestens ein Gettermaterial enthaltenden Klebebandes auf das Flächengebilde,
die Lagerung des derart erhaltenen Verbundes aus Klebeband und Flächengebilde sowie das Entfernen zumindest eines Gettermaterial enthaltenden Teils des Klebebandes von dem Flächengebilde,
wobei das Klebeband zumindest Wasser aus dem Flächengebilde zumindest teilweise aufnehmen kann,
wobei das Gettermaterial ausgewählt ist aus der Gruppe umfassend Barium, Calcium, Calciumsulfat, Calciumchlorid, Calciumoxid, Natriumsulfat, Kaliumcarbonat, Kupfersulfat, Magnesiumperchlorat, Magnesiumsulfat, Lithiumchlorid, Kieselsäuren und Zeolithe sowie Mischungen von zwei oder mehreren der vorstehenden Substanzen.

2. Verfahren gemäß Anspruch 1, umfassend
das Entfernen des Klebebandes von dem Flächengebilde,

3. Verfahren gemäß mindestens einem der Ansprüche 1 und 2, **dadurch gekennzeichnet, dass** die auf dem Flächengebilde aufliegende Klebemasse des Klebebands eine Haftklebemasse oder eine aktivierbare Klebemasse ist.

4. Verfahren gemäß mindestens einem der vorstehenden Ansprüche, **dadurch gekennzeichnet, dass** die auf dem Flächengebilde aufliegende Klebemasse des Klebebands eine aktivierbare Haftklebemasse ist.

5. Verfahren gemäß mindestens einem der vorstehenden Ansprüche, **dadurch gekennzeichnet, dass** die auf dem Flächengebilde aufliegende Klebemasse des Klebebands reversibel eingestellt ist.

6. Verfahren gemäß mindestens einem der vorstehenden Ansprüche, **dadurch gekennzeichnet, dass** die auf dem Flächengebilde aufliegende Klebemasse des Klebebands frei von Klebharzen ist.

7. Verfahren gemäß mindestens einem der vorstehenden Ansprüche, **dadurch gekennzeichnet, dass** das Gettermaterial ausgewählt ist aus der Gruppe umfassend Calciumoxid, Calciumsulfat, Calciumchlorid, pyrogene Kieselsäuren und Zeolithe sowie Mischungen von zwei oder mehreren der vorstehenden Substanzen.

8. Verfahren gemäß mindestens einem der vorstehenden Ansprüche zum Entfernen von Permeaten aus Einsatzmaterialien oder Zwischenprodukten in der Fertigung von elektronischen Aufbauten, aus Anoden oder Katoden, aus leitfähigen Schichten oder Leiterbahnen, aus Lochinjektionsschichten, aus organischen lichtemittierenden oder - absorbierenden Schichten und/oder aus Wirkstoffpflastern.

## Claims

1. Method for removing at least water from a sheet material, comprising bonding of an adhesive tape containing at least one getter material to the sheet material,
storage of the resulting composite of the adhesive tape and the sheet material and removal of at least a part of the adhesive tape containing getter material from the sheet material,
wherein the adhesive tape can at least partially absorb at least water from the sheet material,
wherein the getter material is selected from the group comprising barium, calcium, calcium sulfate, calcium chloride, calcium oxide, sodium sulfate, potassium carbonate, copper sulfate, magnesium perchlorate, magnesium sulfate, lithium chloride, silicas and zeolites and also mixtures of two or more of the abovementioned substances.

2. Method according to Claim 1, comprising removal of the adhesive tape from the sheet material.

3. Method according to at least one of Claims 1 and 2, **characterized in that** the adhesive of the adhesive tape contacting the sheet material is a pressure-sensitive adhesive or an activatable adhesive.

4. Method according to at least one of the preceding claims, **characterized in that** the adhesive of the adhesive tape contacting the sheet material is an activatable pressure-sensitive adhesive.

5. Method according to at least one of the preceding claims, **characterized in that** the adhesive of the adhesive tape contacting the sheet material is reversible.

6. Method according to at least one of the preceding claims, **characterized in that** the adhesive of the adhesive tape contacting the sheet material is free from tackifier resins.

7. Method according to at least one of the preceding claims, **characterized in that** the getter material is selected from the group comprising calcium oxide, calcium sulfate, calcium chloride, pyrogenic silicas and zeolites and also mixtures of two or more of the abovementioned substances.

8. Method according to at least one of the preceding claims for removing permeates from input materials or intermediate products in the manufacture of electronic assemblies, from anodes or cathodes, from conductive layers or conductor tracks, from hole injection layers, from organic light-emitting or -absorbing layers and/or from medicated patches.

## Revendications

1. Procédé pour l'élimination au moins d'eau d'une structure plate, comprenant :
le collage d'une bande adhésive contenant au moins un matériau sorbeur sur la structure plate,
l'entreposage du composite de bande adhésive et structure plate ainsi obtenu, ainsi que
l'élimination d'au moins une partie de la bande adhésive contenant du matériau sorbeur de la structure plate,
la bande adhésive pouvant au moins partiellement absorber au moins de l'eau de la structure plate,
le matériau sorbeur étant choisi dans le groupe comprenant le baryum, le calcium, le sulfate de calcium, le chlorure de calcium, l'oxyde de calcium, le sulfate de sodium, le carbonate de potassium, le sulfate de cuivre, le perchlorate de magnésium, le sulfate de magnésium, le chlorure de lithium, les silices et les zéolithes, ainsi que les mélanges de deux ou plus des substances précédentes.

2. Procédé selon la revendication 1, comprenant :
l'élimination de la bande adhésive de la structure plate.

3. Procédé selon au moins l'une quelconque des revendications 1 et 2, **caractérisé en ce que** la masse adhésive de la bande adhésive posée sur la structure plate est une masse adhésive de contact ou une masse adhésive activable.

4. Procédé selon au moins l'une quelconque des revendications précédentes, **caractérisé en ce que** la masse adhésive de la bande adhésive posée sur la structure plate est une masse adhésive de contact activable.

5. Procédé selon au moins l'une quelconque des revendications précédentes, **caractérisé en ce que** la masse adhésive de la bande adhésive posée sur la structure plate est ajustée de manière réversible.

6. Procédé selon au moins l'une quelconque des revendications précédentes, **caractérisé en ce que** la masse adhésive de la bande adhésive posée sur la structure plate est exempte de résines adhésives.

7. Procédé selon au moins l'une quelconque des revendications précédentes, **caractérisé en ce que** le matériau sorbeur est choisi dans le groupe comprenant l'oxyde de calcium, le sulfate de calcium, le chlorure de calcium, les silices pyrogénées et les zéolithes, ainsi que les mélanges de deux ou plus des substances précédentes.

8. Procédé selon au moins l'une quelconque des revendications précédentes pour l'élimination de perméats de matières premières ou de produits intermédiaires dans la fabrication de composants électroniques, d'anodes ou de cathodes, de couches conductrices ou de pistes conductrices, de couches d'injection de trous, de couches organiques émettant ou absorbant la lumière et/ou de pansements à agents actifs.
